(19) Europäisches Patentamt
European Patent Office
Office européen des brevets

(11) Numéro de publication : **0 146 431**
**B1**

(12) # FASCICULE DE BREVET EUROPÉEN

(45) Date de publication du fascicule du brevet : **19.07.89**

(51) Int. Cl.$^4$ : **H 02 M 7/217**, H 03 F 3/70

(21) Numéro de dépôt : **84402224.4**

(22) Date de dépôt : **06.11.84**

(54) **Redresseur monoalternance a capacités commutées.**

(30) Priorité : **08.11.83 FR 8317726**

(43) Date de publication de la demande : **26.06.85 Bulletin 85/26**

(45) Mention de la délivrance du brevet : **19.07.89 Bulletin 89/29**

(84) Etats contractants désignés : **DE FR GB IT NL**

(56) Documents cités :
**EP-A- 0 072 741**
**DE-A- 3 035 945**
**GB-A- 2 068 189**
**"Operational amplifiers and linear integrated circuits", R.F. COUGHLIN et al. (1982, Prentice-Hall ed.)**

(73) Titulaire : **SGS-THOMSON MICROELECTRONICS S.A.**
**7, Avenue Galliéni**
**F-94250 Gentilly (FR)**

(72) Inventeur : **Caillon, Christian**
**THOMSON-CSF SCPI 173, bld. Haussmann**
**F-75379 Paris Cedex 08 (FR)**
Inventeur : **Terrier, Christian**
**THOMSON-CSF SCPI 173, bld. Haussmann**
**F-75379 Paris Cedex 08 (FR)**

(74) Mandataire : **Rinuy, Santarelli et al**
**14, avenue de la Grande Armée**
**F-75017 Paris (FR)**

**EP 0 146 431 B1**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne les circuits à capacités commutées qui sont des circuits échantillonnées mettant en oeuvre des transferts de charge entre capacités pour simuler notamment le comportement électrique de résistances.

Un but de l'invention est de réaliser avec un tel type de circuit une fonction particulière qui est la fonction de redressement monoalternance d'une tension alternative, à savoir la transmission des alternances d'un signe déterminé et l'élimination des alternances du signe opposé. Cette fonction de redressement doit être aussi peu affectée que possible d'une part par les tensions de seuil des éléments effectuant le redressement proprement dit, et d'autre part par les tensions de décalage à l'entrée des amplificateurs opérationnels éventuellement utilisés.

L'ouvrage « Operational Amplifiers and Linear Integrated Circuits » - R. F. Coughlin et al (Prentice Hall, USA-1982), pages 133-136, décrit un redresseur monoalternance linéaire qui n'est pas du type à capacités commutées. Le document GB-A-2068189 décrit un circuit à compensation de tension de décalage d'un amplificateur opérationnel. La combinaison de ces documents, si elle était possible, ne conduirait pas à la solution selon l'invention.

La présente invention propose un circuit à capacités commutées qui réalise cette fonction de redressement et qui comporte :

un amplificateur opérationnel comportant une entrée non-inverseuse reliée à la masse et une entrée inverseuse ;

une première capacité reliée d'un côté à l'entrée inverseuse et susceptible d'être reliée de l'autre soit à la masse pendant une première phase de chaque période d'échantillonnage soit à l'entrée du redresseur pendant une deuxième phase, disjointe de la première, de chaque période d'échantillonnage ;

une deuxième capacité reliée d'un côté à l'entrée inverseuse et susceptible d'être reliée de l'autre côté à la masse pendant la première phase ou à la sortie du redresseur pendant la deuxième phase ;

un premier transistor à effet de champ ayant sa grille reliée à son drain, monté entre l'entrée inverseuse et la sortie de l'amplificateur opérationnel, conduisant pendant la deuxième phase si le signal à redresser se trouve dans l'alternance ne devant pas être transmise à la sortie ;

un deuxième transistor à effet de champ ayant sa grille reliée à son drain, monté de manière à être connecté entre la sortie de l'amplificateur opérationnel et la sortie du redresseur et à être conducteur pendant la deuxième phase de chaque période échantillonnée si le signal à redresser se trouve dans l'alternance devant être transmise à la sortie ;

un interrupteur fermé pendant la première phase d'échantillonnage, monté en parallèle avec le premier transistor.

Il est prévu en principe une troisième capacité susceptible d'être reliée entre la sortie du circuit et la masse pendant la deuxième phase.

Pour éviter toute ambiguité, on appellera dans tout ce qui suit « drain » des transistors le côté qui est relié à la grille, que le transistor soit à canal n ou à canal p.

La tension de sortie qui ne présente que les alternances d'un signe déterminé de la tension d'entrée, éventuellement amplifiée ou atténuée selon le rapport entre les valeurs des première et seconde capacités, est disponible en permanence aux bornes de la troisième capacité et elle peut être lue aussi bien pendant la première phase que pendant la deuxième phase de chaque période d'échantillonnage ; elle se comporte donc, ce qui est intéressant, comme une tension non échantillonnée (bien que par la nature du redressement qui est effectué de manière échantillonnée, cette tension de sortie se présente en marches d'escalier).

On peut prévoir avantageusement un amplificateur à gain unitaire relié a cette troisième capacité pour permettre de lire la tension de sortie sans la décharger.

Le circuit ainsi constitué est tout particulièrement adapté à être intégré dans une technologie MOS (Metal-Oxyde-Semiconducteur).

D'autres caractéristiques et avantages de l'invention apparaîtront à la lecture de la description détaillée qui suit et qui est faite en référence aux dessins annexés dans lesquels la figure unique représente le schéma de base du circuit redresseur selon l'invention.

L'entrée du circuit redresseur est désignée par E, sa sortie par S. Toutefois, une sortie S' après un amplificateur tampon peut aussi être prévue.

La tension d'entrée alternative à redresser est désignée par Ve et la tension de sortie redressée est Vs sur la sortie S ou Vs' sur la sortie S'

L'ensemble du circuit fonctionne de manière échantillonnée, avec des interrupteurs qui se ferment et s'ouvrent selon deux phases disjointes, à chaque période d'échantillonnage. Sur la figure, la lettre a, à côté d'un interrupteur, signifie que cet interrupteur se ferme uniquement pendant la première phase a de chaque période ; la lettre b signifie au contraire qu'il ne se ferme que pendant la seconde phase b.

L'entrée E du circuit est reliée par un interrupteur I1, fermé pendant la phase b, à une première borne d'une première capacité C1 dont l'autre borne est reliée à l'entrée inverseuse d'un amplificateur opérationnel A0 ; la première borne de la capacité peut être reliée à la masse pendant la phase a par un deuxième interrupteur I2.

L'amplificateur opérationnel A0 a aussi une entrée non inverseuse reliée à la masse.

Un premier transistor à effet de champ T1 est prévu, ayant son drain relié à sa grille et jouant donc le rôle d'élément redresseur puisqu'il n'est conducteur que si sa tension drainsource dépasse

sa tension de seuil propre qu'on appellera Vt1. Ce transistor T1 est connecté entre l'entrée inverseuse et la sortie de l'amplificateur A0.

Un deuxième transistor à effet de champ T2 est également prévu, ayant aussi son drain relié à sa grille et jouant donc aussi le rôle d'élément redresseur à seuil. Il a une tension de seuil Vt2 égale ou non à Vt1, et il est connecté entre la sortie de l'amplificateur A0 et un point p qui est relié par un interrupteur I3 à une première borne d'une deuxième capacité C2 et par un interrupteur I4 à la sortie S du circuit. Ces deux interrupteurs sont fermés pendant la deuxième phase b.

Un autre interrupteur I5, fermé pendant la première phase a, permet de relier cette première borne de la capacité C2 à la masse. La capacité C2 est par ailleurs reliée par son autre borne à l'entrée inverseuse de l'amplificateur A0.

Un interrupteur I6 permet de court-circuiter, pendant la première phase a, le transistor T1.

Une troisième capacité C3 est connectée entre la sortie S et la masse, au moins pendant la seconde phase. C'est aux bornes de cette capacité C3 qu'est obtenue la tension alternative redressée ne présentant plus que des alternances d'un signe donné.

On peut prévoir en outre un amplificateur opérationnel A0', monté en suiveur de tension à gain unitaire pour fournir une tension de sortie Vs' égale à Vs mais obtenue sous basse impédance et évitant la décharge de la capacité C3 entre deux périodes d'échantillonnage.

L'amplificateur a alors une entrée (non-inverseuse) reliée à la sortie S et une autre entrée (inverseuse) reliée à sa propre sortie S'

Le fonctionnement du circuit est expliqué ci-après en supposant d'abord que les deux transistors T1 et T2 sont des transistors à canal n à tensions de seuil positives, que le drain de T1 est relié à l'entrée de l'amplificateur A0 et que le drain de T2 est reliée à la sortie de l'amplificateur A0.

Pendant la phase a de chaque période, les interrupteurs, I2, I5 et I6 se ferment ; la capacité C1 se charge à la tension Veo présente à l'entrée de l'amplificateur A0 ; ici Veo est égal à la tension Voff de décalage d'entrée de l'amplificateur A0 qui est bouclé en gain unitaire par l'interrupteur I6 ; la capacité C2 se charge aussi a Voff ; la tension de sortie Vso de l'amplificateur est égale à sa tension d'entrée Veo.

Pendant la phase b qui suit, le raisonnement est différent selon que l'on est dans une alternance positive ou négative de la tension d'entrée Ve à redresser.

1. Alternance positive : Ve positif

Les interrupteurs I2, I5 et I6 s'ouvrent ; les interrupteurs I1, I3, I4 se ferment.

La capacité C1 chargée à Voff transmet instantanément le potentiel Ve sur l'entrée inverseuse de l'amplificateur AO. Cette entrée était à Voff ; elle tend à passer à Ve + Voff, de sorte que la sortie Vso tend à devenir très négative, l'amplificateur A0 étant initialement en boucle ouverte.

Le transistor T1 qui était bloqué pendant la phase a du fait de sa tension drain-source nulle devient rapidement conducteur car sa tension drain-source devient fortement positive.

Dans ces conditions, la tension d'entrée Veo de l'amplificateur est ramenée pratiquement à Voff, et tout se passe comme si cette tension était appliquée à l'ensemble en série des capacités C2 et C3, de sorte qu'on retrouve aux bornes de C3 une fraction C2/C2 + C3 de la tension de décalage Voff, c'est à dire une valeur très proche de zéro, surtout si la valeur de C2 est très inférieure à celle de C3.

Les alternances positives de la tension d'entrée Ve sont donc supprimées et laissent Vs très proche de zéro.

On vérifie qu'alors le transistor T2 reste bloqué (tension négative à peu près égale à -Vt1 sur son drain et tension pratiquement nulle sur sa source).

2. Alternances négatives : Ve négatif

Les interrupteurs I2, I5 et I6 s'ouvrent ; les interrupteurs I1, I3, I4 se ferment.

La capacité C1 chargée à Voff transmet instantanément le potentiel Ve sur l'entrée inverseuse de l'amplificateur A0. Cette entrée étant à Voff ; elle tend à passer à Ve + Voff, de sorte que, Ve étant négatif, la tension de sortie Vso tend à devenir très positive, l'amplificateur A0 étant initialement en boucle ouverte.

Le transistor T1 qui était bloqué pendant la phase a est confirmé dans ce blocage puisque sa tension de drain devient négative, et sa tension de source positive.

Au contraire le transistor T2 est largement rendu conducteur par sa tension drain fortement positive.

Des charges électriques positives peuvent donc être fournies par l'amplificateur A0 à la capacité C2 à travers le transistor T2 pour ramener l'ensemble à un état d'équilibre dans lequel la somme des charges stockées sur les capacités C1 et C2 est toujours C1Voff + C2Voff puisqu'aucune charge n'a pu être amenée du côté des armatures réunies des deux capacités (impédance d'entrée infinie de l'amplificateur AO) ; la tension d'entrée Veo de l'amplificateur revient a Voff (en fait à Voff + Vso/A si A est le gain de l'amplificateur, mais on considérera ce gain comme infini).

Comme la charge de C1 est maintenant C1 (Voff-Ve) et celle de C2 est C2 (Voff-Vs) et que cette somme doit toujours être égale à la somme de charges initiales C1Voff + C2Voff, on en déduit que Vs prend la valeur :

$$Vs = C1/C2\ Ve$$

Pour les alternances négatives par conséquent la tension de sortie reproduit, inversée et éventuellement atténuée ou amplifiée selon le rapport des capacités C1 et C2 si elles ne sont pas égales.

La tension de décalage Voff n'intervient pas car elle s'élimine dans l'égalité de charges définie ci-

dessus.

La sortie Vso de l'amplificateur reste à une valeur égale à Vs + Vt2 juste suffisante pour maintenir le transistor T2 en conduction.

La capacité de sortie C3 se charge en conséquence à la tension Vs et conserve cette charge lorsque la phase b se termine, et que l'interrupteur 14 est à nouveau ouvert.

L'amplificateur supplémentaire A0' monté en suiveur fournit en permanence une tension redressée sous basse impédance sans décharger la capacité C3.

Il faut noter qu'il peut être souhaitable de prévoir, lors de la phase b, que l'interrupteur I4 se ferme légèrement après l'interrupteur Il, surtout si la capacité C2 est notablement plus faible que la capacité C3, pour éviter, en cas d'alternance négative décroissante, que la capacité C2, retransmettant le potentiel Vs de la capacité C3, ne transmette sur l'entrée négative de l'amplificateur A0 un potentiel positif prenant le dessus sur le potentiel négatif Ve transmis par la capacité C1, auquel cas le transistor T2 se bloquerait, le transistor T1 conduirait et on perdrait le bénéfice de la mise en mémoire de la tension Voff dans les capacités C1 et C2.

Pour terminer la description de l'invention, on peut signaler que les transistors T1 et T2 peuvent être chacun indifféremment à canal p ou à canal n ; que leur drain est connecté à leur grille mais que pour chacun des transistors on peut prévoir que c'est soit son drain, soit sa source qui est relié à la sortie de l'amplificateur opérationnel A0.

Toutefois, si les transistors sont de même type, la source de l'un doit être reliée au drain de l'autre à la sortie de l'amplificateur opérationnel, tandis que s'ils sont de type opposés, les deux drains ou les deux sources doivent être réunies à la sortie de l'amplificateur. Il y a donc huit cas de figures possibles et, selon la combinaison choisie, le circuit redressera soit les alternances positives, soit les alternances négatives.

Par exemple, si le transistor T1 est à canal n et le transistor T2 à canal p, l'un deux doit être globalement retourné. Si c'est le transistor T2, le circuit conservera toujours les alternances négatives inversées ; si c'est le transistor T1, le circuit conservera les alternances positives inversées.

Les tensions de seuil Vt1 et Vt2 des transistors ont de préférence des valeurs aussi proches que possible de zéro ; ces valeurs peuvent être comprises entre — 1 volt et + 1 volt par exemple.

Enfin le circuit de redressement peut avoir un gain programmable par mise en service de capacités différentes réalisant des valeurs choisies de C1 et/ou C2.

## Revendications

1. Redresseur monoalternance, constitué par un circuit à capacités commutées comportant.

un amplificateur opérationnel (A0) comportant une entrée non-inverseuse reliée à la masse et une entrée inverseuse ;

une première capacité (C1) reliée d'un côté à l'entrée inverseuse et susceptible d'être reliée de l'autre soit à la masse pendant une première phase (a) de chaque période d'échantillonnage (I2) soit à l'entrée (E) du redresseur pendant une deuxième phase (b), disjointe de la première, de chaque période d'échantillonnage (I1) ;

une deuxième capacité (C2) reliée d'un côté à l'entrée inverseuse et susceptible d'être reliée de l'autre côté à la masse pendant la première phase (a) (I5) ou à la sortie (S) du redresseur pendant la deuxième phase (I3) ;

un premier transistor à effet de champ (T1) ayant sa grille reliée à son drain, monté entre l'entrée inverseuse et la sortie de l'amplificateur opérationnel (A0), conduisant pendant la deuxième phase (b) si le signal à redresser se trouve dans l'alternance ne devant pas être transmise à la sortie (S) ;

un deuxième transistor à effet de champ (T2) ayant sa grille reliée à son drain, monté de manière à être connecté entre la sortie de l'amplificateur opérationnel (A0) et la sortie (S) du redresseur et à être conducteur pendant la deuxième phase (b) de chaque période échantillonnée si le signal à redresser se trouve dans l'alternance devant être transmise à la sortie (S) ;

un interrupteur (I6) fermé pendant la première phase (a) d'échantillonnage, monté en parallèle avec le premier transistor (T1).

2. Redresseur selon la revendication 1, caractérisé en ce qu'il comporte une troisième capacité (C3) reliée entre la sortie (S) du circuit et la masse.

3. Redresseur selon l'une des revendications 1 et 2, caractérisé en ce que la deuxième capacité (C2) est reliée à la sortie (S) du redresseur par deux interrupteurs (I3, I4) fermés pendant la deuxième phase (b), en série, le deuxième transistor (T2) étant relié au point de jonction (P) de ces deux interrupteurs.

4. Redresseur selon l'une des revendications 1 à 3, caractérisé en ce que la sortie (S) du redresseur proprement dit est reliée à l'entrée d'un autre amplificateur opérationnel (A0') bouclé en suiveur de tension à gain unitaire.

## Claims

1. A one-way rectifier constituted by a circuit with switched capacitors comprising :

an operational amplifier (A0) comprising a non-inverting input connected to earth and an inverting input ;

a first capacitor (C1) connected on one side to the inverting input and capable of being connected on the other either to earth during a first phase (a) of each sampling period (I2) or to the input (E) of the rectifier during a second phase (b), disconnected from the first, of each sampling period (I1) ;

a second capacitor (C2) connected on one side to the inverting input and capable of being connected on the other side to earth during the first

phase (a) (I5) or to the output (S) of the rectifier during the second phase (I3) ;

a first field effect transistor (T1) having its gate connected to its drain, mounted between the inverting input and the output of the operational amplifier (A0), which conducts during the second phase (b) if the signal to be rectified is in the alternation which cannot be transmitted to the output (S) ;

a second field effect transistor (T2) having its gate connected to its drain, mounted so as to be connected between the output of the operational amplifier (A0) and the output (S) of the rectifier and to conduct during the second phase (b) of each sampled period if the signal to be rectified is in the alternation which can be transmitted to the output (S) ;

a switch (I6) which is closed during the first phase (a) of sampling, and which is mounted in parallel with the first transistor (T1).

2. A rectifier according to Claim 1, characterized in that it comprises a third capacitor (C3) connected between the output (S) of the circuit and earth.

3. A rectifier according to one of Claims 1 and 2, characterized in that the second capacitor (C2) is connected to the output (S) of the rectifier by two switches (I3, I4) in series, which are closed during the second phase (b), the second transistor (T2) being connected to the junction point (P) of these two switches.

4. A rectitier according to one of Claims 1 to 3, characterized in that the output (S) of the rectifier properly so called is connected to the input of another operational amplifier (A0') in a voltage follower loop with unitary gain.

## Patentansprüche

1. Einweg-Gleichrichter, der von einer Schaltung mit geschalteten Kapazitäten gebildet wird und folgende Bestandteile umfaßt :

Einen Operationsverstärker (A0), der einen mit der Masse verbundenen nichtinvertierenden Eingang sowie einen invertierenden Eingang besitzt,

eine erste Kapazität (C1), die auf der einen Seite mit dem invertierenden Eingang verbunden ist und die auf der anderen Seite während einer ersten Phase (a) einer jeden Abtastperiode (I2) mit der Masse oder während einer zweiten Phase (b) einer jeden Abtastperiode (I1), die von der ersten Phase verschieden ist, mit dem Eingang (E) des Gleichrichters verbunden werden kann,

eine zweite Kapazität (C2), die auf der einen Seite mit dem invertierenden Eingang verbunden ist und auf der anderen Seite während der ersten Phase (a) (I5) mit der Masse oder während der zweiten Phase (I3) mit dem Ausgang (S) des Gleichrichters verbunden werden kann,

einen ersten Feldeffekttransistor (T1), dessen Gate-Anschluß mit seinem Senken-Anschluß verbunden ist, der zwischen den invertierenden Eingang und den Ausgang des Operationsverstärkers (A0) geschaltet ist und der während der zweiten Phase (b) leitet, wenn das gleichzurichtende Signal sich in der Halbwelle befindet, die nicht an den Ausgang (S) übertragen werden soll,

einen zweiten Feldeffekttransistor (T2), dessen Gate-Anschluß mit seinem Senken-Anschluß verbunden ist, der so angeordnet ist, daß er zwischen den Ausgang des Operationsverstärkers (A0) und den Ausgang (S) des Gleichrichters geschaltet ist und der während der zweiten Phase (b) einer jeder Abtastperiode leitend ist, wenn das gleichzurichtende Signal sich in der Halbwelle befindet, die an den Ausgang (S) übertragen werden soll, sowie einen Unterbrecher (I6), der während der ersten Phase (a) der Abtastung geschlossen und der parallel zum ersten Transistor (T1) geschaltet ist.

2. Gleichrichter nach Anspruch 1, dadurch gekennzeichnet, daß er eine dritte Kapazität (C3) umfaßt, die zwischen den Ausgang (S) der Schaltung und die Masse geschaltet ist.

3. Gleichrichter nach einem der Ansprüche 1 oder 2, dadurch gekennzeichnet, daß die zweite Kapazität (C2) mit dem Ausgang (S) des Gleichrichters durch zwei Unterbrecher (I3, I4) verbunden ist, die während der zweiten Phase (b) geschlossen sind und in Reihe liegen, wobei der zweite Transistor (T2) mit dem Verbindungspunkt (P) der beiden Unterbrecher verbunden ist.

4. Gleichrichter nach einem der Ansprüche 1 bis 3, dadurch gekennzeichnet, daß der Ausgang (S) des Gleichrichters genau gesagt mit dem Eingang eines weiteren Operationsverstärkers (A0') verbunden ist, der als Spannungsfolger mit einem Gewinn « Eins » rückgekoppelt ist.

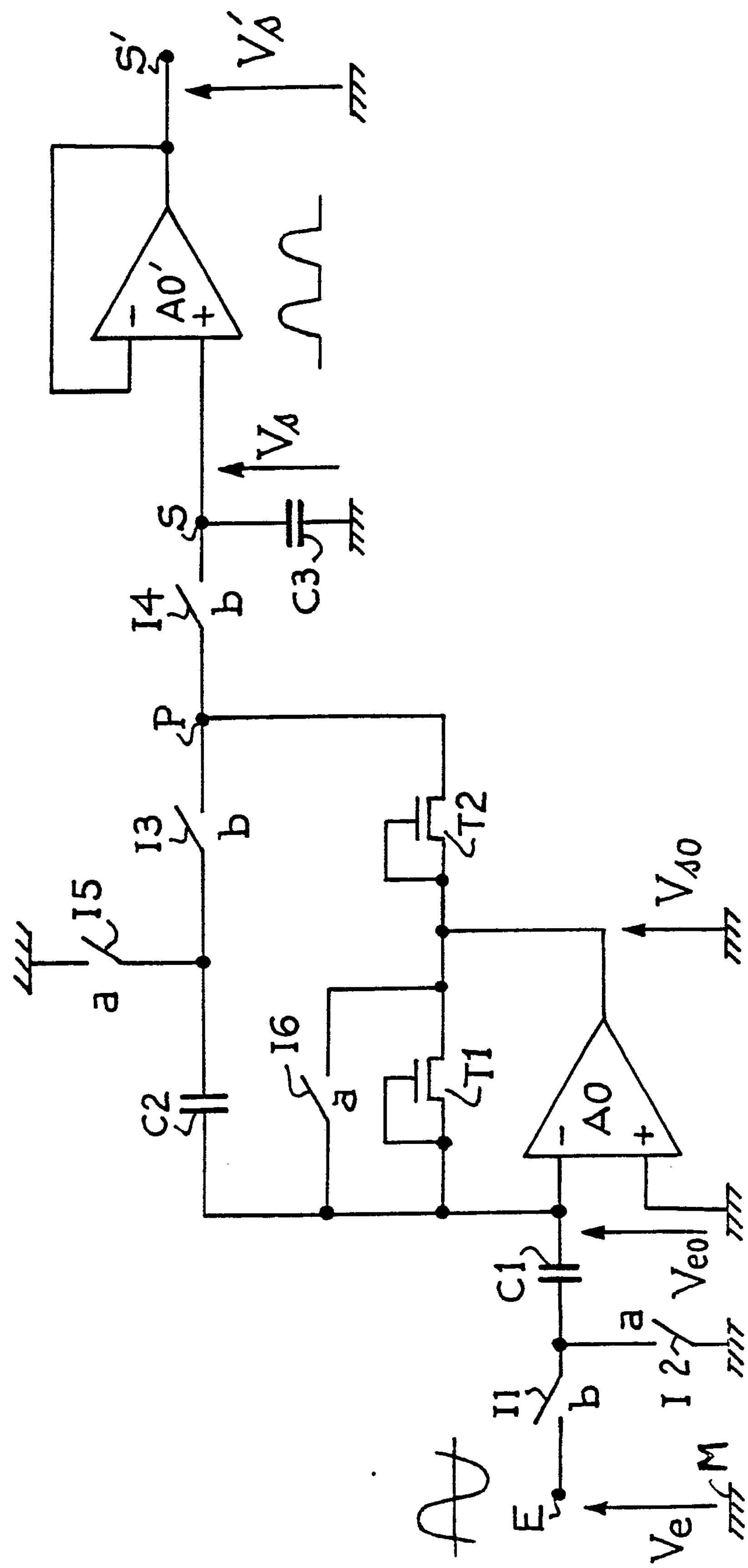
S'
S
P
E
M
AO'
AO
C1
C2
C3
T1
T2
I1
I2
I3
I4
I5
I6
a
b